Europäisches Patentamt

European Patent Office

Office européen des brevets

(19)

(11) Veröffentlichungsnummer: **0 309 921**
**B1**

(12) # EUROPÄISCHE PATENTSCHRIFT

(45) Veröffentlichungstag der Patentschrift:
01.08.90

(51) Int. Cl.⁵: **G01R 23/02**

(21) Anmeldenummer: 88115590.7

(22) Anmeldetag: 22.09.88

(54) Verfahren zur Ermittlung der Frequenz eines abgetasteten symmetrischen Signals aus einer Vorzeicheninformation.

(30) Priorität: 30.09.87 DE 3733110

(43) Veröffentlichungstag der Anmeldung:
05.04.89 Patentblatt 89/14

(45) Bekanntmachung des Hinweises auf die Patenterteilung:
01.08.90 Patentblatt 90/31

(84) Benannte Vertragsstaaten:
AT BE CH DE ES FR GB GR IT LI NL SE

(56) Entgegenhaltungen:
FR-A- 2 158 720
US-A- 4 288 664

W.Richter,Grundlagen der elektrischen
Messtechnik,VEB-Verlag,Technik,Berlin
(1985),S.272-274

(73) Patentinhaber: Siemens Aktiengesellschaft,
Wittelsbacherplatz 2, D-8000 München 2(DE)

(72) Erfinder: Müller, Eugen, Prof., Dr.-Ing., Birgweg 8,
D-8021 Hohenschäftlarn(DE)
Erfinder: Kuhn, Frank, Dipl.-Ing., Franz-Kaim-Strasse 7,
D-8000 München 71(DE)

**Beschreibung**

Die Erfindung bezieht sich auf Verfahren zur Ermittlunq der Frequenz eines abgetasteten periodischen symmetrischen ersten Signals, bei dem ein Abtasttakt einer Frequenz bereitgestellt wird, deren Wert wenigstens das Doppelte der Frequenz dieses ersten Signals beträgt, sowie auf eine Anordnung zur Durchführung dieser Verfahren.

Aus dem Buch "Grundlagen der elektrischen Meßtechnik", Richter, VEB Verlag Technik Berlin, 1985, Seiten 272–274 ist bereits ein Verfahren zur Ermittlung der Frequenz eines abgetasteten periodischen Signals bekannt, bei dem ein Abtasttakt einer Frequenz bereitgestellt wird, deren Wert wenigstens das Doppelte der Frequenz des Signals beträgt.

Aus dem US-Patent 4 288 664 ist es weiter bekannt, aus einem periodischen Signal durch Abtastung eine digitale binäre Vorzeichenimpulsfolge abzuleiten.

Bei zeitkontinuierlichen Signalen läßt sich die Frequenz indirekt über eine Impulszählung zwischen Nulldurchgängen während einer Periodendauer mit Hilfe eines höherfrequenten quarzgenauen Pulses ermitteln. Bei zeitdiskreten Signalen läßt sich der Zeitpunkt eines Nulldurchgangs dagegen nur mit beträchtlichem Aufwand durch Interpolation bestimmen.

Aufgabe der Erfindung ist es, ein einfacheres Verfahren zur Messung der Frequenz zeitdiskreter Signale anzugeben.

Diese Aufgabe wird erfindungsgemäß mit den Merkmalen des Anspruchs 1 gelöst.

Eine Variante für den Fall, daß der Bereich vorab bekannt ist, ergeben die Merkmale des Anspruchs 2.

Eine Anordnung zur Durchführung dieser Verfahren beinhalten die Merkmale des Anspruchs 3.

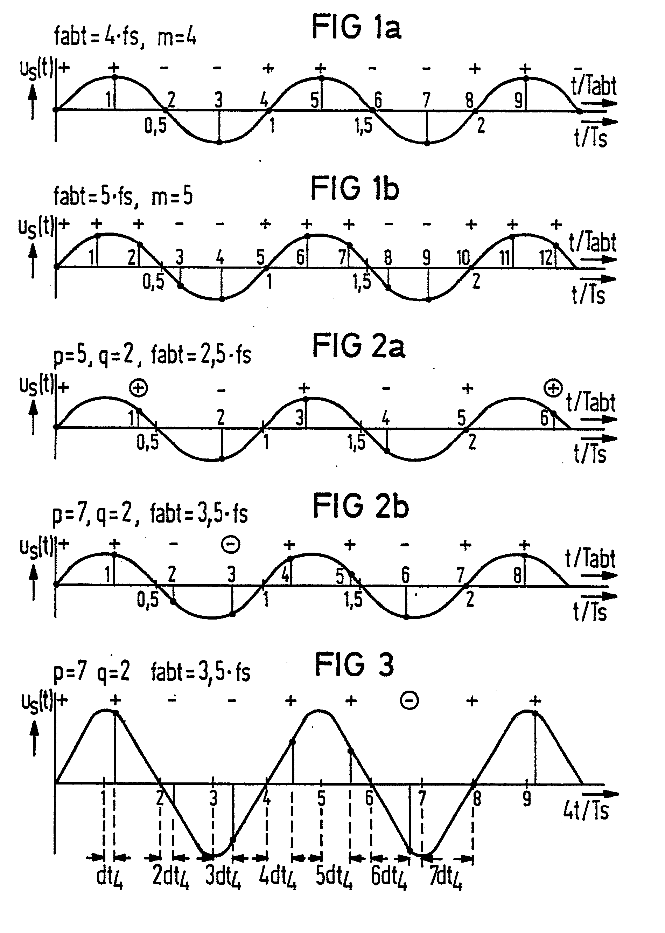

Die Erfindung beruht auf der Erkenntnis, daß sich bei Abtastung einer sinusförmigen Zeitfunktion mit einer Abtastfrequenz $f_{abt}$ bei Erfüllung des Abtasttheorems das Verhältnis L der Abtastfrequenz $f_{abt}$ zur Signalfrequenz $f_s$ und damit die Signalfrequenz $f_s$ aus der Vorzeichenfolge der Abtastwerte ableiten läßt, weil infolge der Periodizität der Sinusfunktion sich immer ein periodisches Muster der Vorzeichenfolge ergibt. Dies zeigen die Figuren 1a,1b, 2a,2b sowie 3.

Figuren 1a und 1b gelten für den Fall, daß $f_{abt} = m \cdot f_s$, wobei m ganzzahlig ist. Fig. 1a zeigt für den Fall m = 4 die abzutastende Sinusfunktion $u_s(t)$, die Abtastwerte und deren Vorzeichen VZ. Fig. 1b zeigt das entsprechende für m = 5. Die jeweils entgegengesetzten Vorzeichen VZ können dann auftreten, wenn der erste Abtastwert nicht, wie dargestellt, kurz nach dem positiven, sondern nach dem negativen Nulldurchgang entnommen wird. Beide Vorzeichenfolgen sind periodisch.

Die Figuren 2a und 2b zeigen Beispiele für $f_{abt} = L \cdot f_s$ mit L = p/q, wobei p und q ganzzahlig und teilerfremd sind.

Fig. 2a zeigt neben der Sinusfunktion $u_s(t)$ und den Abtastwerten die Vorzeichenfolge für $f_{abt} = 2,5 \cdot f_s$ mit p = 5 und q = 2. Die mit einem Kreis umgebenen Vorzeichen VZ sind Ausnahmevorzeichen AVZ, die zwar periodisch auftauchen, aber nicht in ein Grundmuster passen, wie es Fig. 1a oder Fig. 1b zeigt. Es ist zu erkennen, daß p die Anzahl der Abtastwerte von einem Ausnahmevorzeichen zum anderen ist.

Fig. 2b zeigt die Vorzeichenfolge für $f_{abt} = 3,5 \cdot f_s$ mit p = 7 und q = 2. Daß die gezeigten Ausnahmevorzeichen tatsächlich solche sind, wird später aus der Fig. 4 deutlich.

Fig. 3 zeigt für das Beispiel nach Fig. 2b die schrittweise Verschiebung des Abtastzeitpunktes gegenüber der Sinusfunktion $u_s(t)$ und dabei die Entstehung der Ausnahmevorzeichen nach n = 7 Abtastwerten.

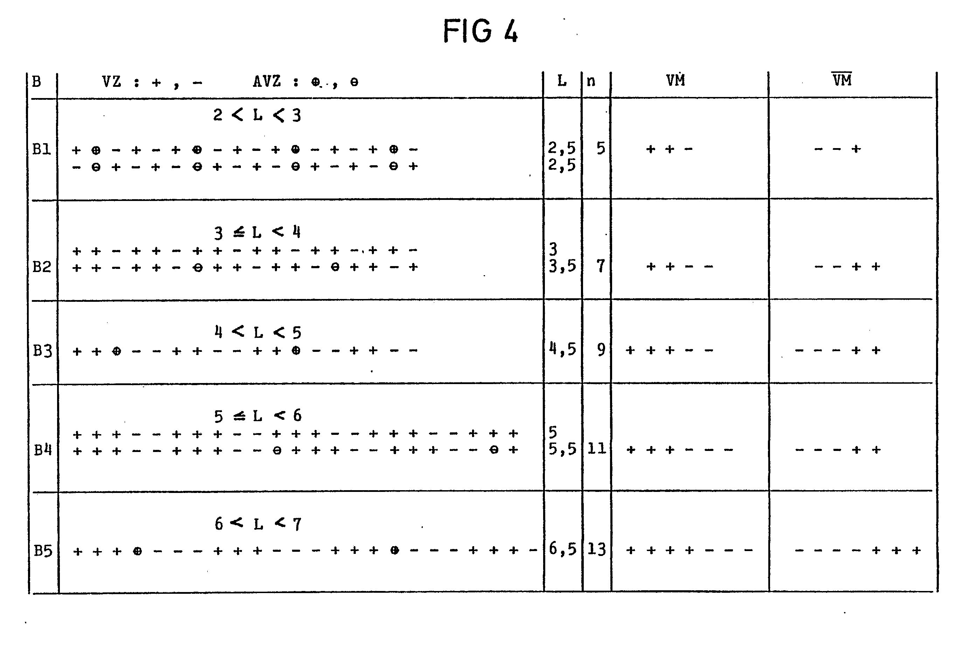

Überlegungen über das Auftreten von Ausnahmevorzeichen AVZ ergaben, daß es für eine mathematische Erfassung zweckmäßig ist, für das Verhältnis L mehrere Bereiche B1 - B5 usw. vorzusehen, die in Fig. 4 in fünf übereinander angeordneten Feldern dargestellt sind. Aus Spalte 1 ist die Bereichsbezeichnung B zu ersehen, in Spalte 2 ist in jedem Feld oben der Wertebereich des Verhältnisses L angegeben. Darunter finden sich jeweils Vorzeichenfolgen mit den Grenzwerten des Bereichs (soweit diese enthalten sind) und einem ausgewählten mittleren Wert. In der Spalte 3 finden sich die Werte L und in der Spalte 4 die Werte n, die den zeitlichen Abstand der Ausnahmevorzeichenimpulse AVZ als Vielfaches von $T_{abt}$ angeben.

Bezogen auf die Perioden der Vorzeichenimpulsfolgen gilt:
Im Bereich B1 fallen n Abtastwerte in n-1 Halbschwingungen des Signals $u_s(t)$

$$n \cdot T_{abt} = (n-1) \cdot T_s/2 \quad (1)$$

(da $f_{abt} > 2 \cdot f_s$ gilt $T_{abt} < T_s/2$)

Im Bereich B2 fallen n Abtastwerte in n + 1 Viertelschwingungen des Signals $u_s(t)$. Wie Fig. 3 zeigt, wandern die Abtastwerte bei jedem Abtastwert um $dt_4$ weiter als $T_s/4$

$$n \cdot T_{abt} = (n + 1) \cdot T_s/4. \quad (2)$$

Im Bereich B3 fallen n Abtastwerte in n - 1 Viertelschwingungen des Signals $u_S(t)$

$$n \cdot T_{abt} = (n - 1) \cdot T_S/4. \quad (3)$$

Auf gleiche Art und Weise lassen sich für die Bereiche B4 und B5 und weitere Bereiche Beziehungen zwischen n und
$$L = T_S/T_{abt} = f_{abt}/f_S$$
ableiten.

Setzt man in die Gleichungen mit (1) bis (3) usw. L für $T_S/T_{abt}$, so gelangt man zu folgenden Gleichungen zur Berechnung von n

$$B1 \qquad 2 < L < 3 \quad : \quad n = \frac{1}{1 - 2/L}$$

$$B2 \qquad 3 \leqslant L < 4 \quad : \quad n = \frac{1}{4/L - 1}$$

$$B3 \qquad 4 < L < 5 \quad : \quad n = \frac{1}{1 - 4/L}$$

$$B4 \qquad 5 \leqslant L < 6 \quad : \quad n = \frac{1}{6/L - 1}$$

$$B5 \qquad 6 < L < 7 \quad : \quad n = \frac{1}{1 - 6/L}$$

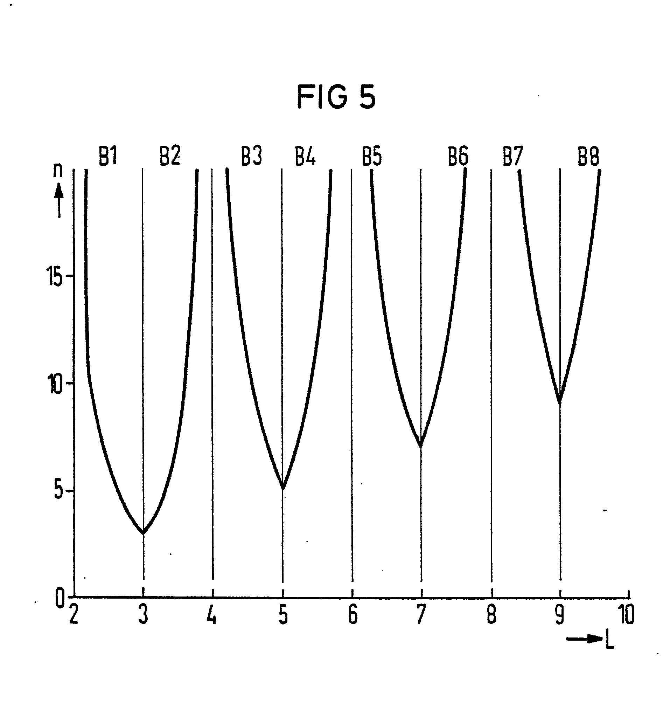

Fig. 5 zeigt die Anzahl von Abtastwerten n, nach denen ein Ausnahmevorzeichen AVZ erfolgt, als Funktion von dem Verhältnis L. Der Bereich L < 2 ist als Folge des Abtast-Theorems ein verbotener Bereich, in dem eine eindeutige Zuordnung der Vorzeichenimpulsfolge VZ zur Signalfrequenz $f_S$ nicht möglich ist. Weiter können Frequenzermittlungen für gerade Werte von L usw. nicht durchgeführt werden, da hier keine Ausnahmevorzeichenimpulse AVZ entstehen.

Die Frequenzbestimmung wird um so genauer, je öfter hintereinander die Anzahl der Abtastwerte n festgestellt und anschließend ein mittlerer Wert von n ermittelt wird. Ist bekannt, daß die zu ermittelnde Frequenz innerhalb eines bestimmten Bereiches B1 - B5 liegt, erübrigt sich die Bereichserkennung.

Eine Anordnung zur Durchführung des erfindungsgemäßen Verfahrens ist dadurch gekennzeichnet, daß ein UND-Gatter vorgesehen ist, dessen erster Eingang mit einem Eingang für die Vorzeichenimpulse und dessen zweiter Eingang mit einem Eingang für den Meßtakt verbunden sind, daß ein Schieberegister zur Seriell-Parallel-Umsetzung vorgesehen ist, dessen serieller Eingang mit dem Ausgang des UND-Gatters und dessen Takteingang mit einem Eingang für den Abtasttakt verbunden sind, daß eine Erkennungsfenster-Einstelleinrichtung vorgesehen ist, deren Eingänge mit den parallelen Ausgängen des Schieberegisters verbunden sind, daß zwei Ausnahmevorzeichen-Erkennungseinrichtungen vorgesehen sind, deren erste Eingänge mit den Ausgängen der Erkennungsfenster-Einstellvorrichtung verbunden sind, daß ein erstes ODER-Gatter vorgesehen ist, dessen erster Eingang mit dem Ausgang der ersten Ausnahmevorzeichen-Erkennungseinrichtung und dessen zweiter Eingang mit dem Ausgang der zweiten Ausnahmevorzeichen-Erkennungseinrichtung verbunden sind, daß eine Bereichs-Erkennungseinrichtung vorgesehen ist, deren Eingang mit dem Ausgang des UND-Gatters, deren erste Ausgänge für ein Vergleichsmuster mit den zweiten Eingängen der ersten Ausnahmevorzeichen-Erkennungseinrichtung, deren zweite Ausgänge für das invertierte Vergleichsmuster mit den zweiten Eingängen der zweiten Ausnahmevorzeichen-Erkennungseinrichtung und deren dritte Ausgänge mit einem Steuereingang der Erkennungsfenster-Einstellvorrichtung verbunden sind, daß ein Inverter vorgesehen ist, dessen Eingang mit dem Eingang für den Meßtakt verbunden ist, daß ein zweites ODER-Gatter vorgesehen ist, dessen erster Eingang mit dem Ausgang des Inverters und dessen zweiter Ausgang mit einem Eingang für Rücksetzimpulse verbunden sind, daß ein Zähler vorgesehen ist, dessen Eingang mit dem Ausgang des ersten ODER-Gatters und dessen Rücksetzeingang mit dem Ausgang des zweiten ODER-Gatters verbunden sind, daß flankengesteuerte D-Flipflops vorgesehen sind, deren eine Eingänge mit den Ausgängen des Zählers, deren andere Eingänge mit vierten Ausgängen der Bereichs-Erkennungseinrichtung, deren Takteingänge mit dem Ausgang des Inverters und deren Rücksetzeingänge mit dem Eingang für Rücksetzimpulse verbunden sind, und daß ein Umcodierer vorgesehen ist, dessen Eingänge mit den Ausgängen der D-Flipflops verbunden sind und dessen Ausgänge einem binären Code für eine Ziffernanzeige abgeben.

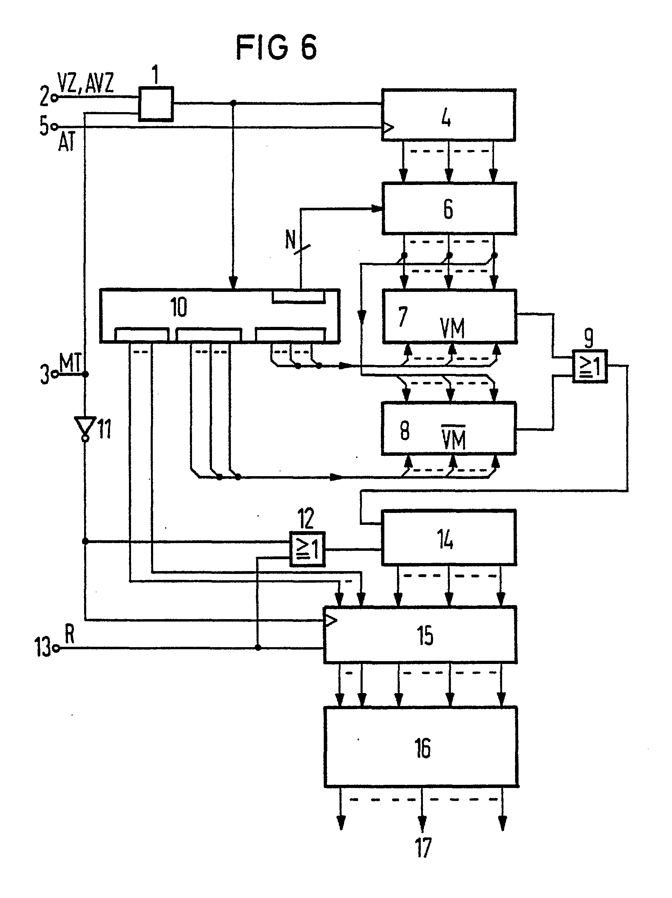

Fig. 6 zeigt diese Anordnung. Sie enthält ein UND-Gatter 1, einen Eingang 2 für Vorzeichenimpulse VZ und Ausnahmevorzeichenimpulse AVZ, einen Eingang 3 für den Meßtakt MT, ein Schieberegister 4, einen Eingang 5 für den Abtasttakt AT, eine Erkennungsfenster-Einstellvorrichtung 6, Ausnahmevorzeichen-Erkennungseinrichtungen 7 und 8, ODER-Gatter 9 und 12, eine Bereichs-Erkennungseinrichtung 10, einen Inverter 11, einen Eingang 13 für Rücksetzimpulse R, einen Zähler 14, flankengesteuerte D-Flipflops (latches) 15, einen Umkodierer 16 und einen Ausgang 17 zur Ziffernanzeige.

Während am Eingang 3 ein Impuls des Meßtaktes MT anliegt, wird eine Vorzeichenimpulsfolge vom Eingang 2 über das UND-Gatter 1 mit dem Abtasttakt AT am Eingang 5 in das Schieberegister 4 eingegeben. Die Bereichs-Erkennungseinrichtung 10, z.B. ein Mikroprozessor, gibt an die Ausnahmevorzeichen-Erkennungseinrichtung 7 je nach Bereich ein bestimmtes Vergleichsmuster VM und an die Ausnahmevorzeichen-Erkennungseinrichtung 8 das invertierte Vergleichsmuster $\overline{VM}$. Diese Vergleichsmuster sind in Fig. 4 rechts außen gezeigt. Sie besitzen eine Stellenzahl, die vom aktuellen Bereich abhängt. Die Erkennungsfenster-Einstellvorrichtung 6 bewirkt von der Bereichs-Erkennungseinrichtung 10 über eine n-fache Leitung gesteuert, daß nur soviel Bit aus dem Schieberegister 4 an die Ausnahmevorzeichen-Erkennungseinrichtungen 7 und 8 gelangen, wie auch die Vergleichsmuster aufweisen. Gibt eine der beiden Ausnahmevorzeichen-Erkennungseinrichtungen 7 und 8 ein Erkennungssignal ab, dann gelangt dieses über das ODER-Gatter 9 zum Eingang des Zählers 14. Mit jedem neuen negativen Impuls des Meßtaktes MT, der über den Inverter 11 in das ODER-Gatter 12 zum Zähler 14 gelangt, wird dieser zurückgesetzt. Das Zählergebnis des Zählers 14 wird an flankengesteuerte D-Flipflops (latches) 15 abgegeben, deren Inhalt im Umkodierer 16 in Signale für eine Ziffernanzeige der Frequenz umgesetzt werden wobei die Bereichs-Erkennungseinrichtung 10 den Bereich signalisiert. Mit einem Rückstellimpuls R können die flankengesteuerten D-Flipflops zurückgestellt werden.

Die Störsicherheit der Schaltung läßt sich durch die Benutzung von Vergleichsmustern VM erhöhen, die mehrere Ausnahmevorzeichen AVZ umfassen.

Das geschilderte Verfahren läßt sich beispielsweise in Ton-Disablern für Echokompensatoren anwenden, in denen die Frequenz eines Tones von 2100 Hz ± 21 Hz empfangen werden muß. Bei einer Abtastfrequenz von 8 kHz werden Frequenzen zwischen 2075 und 2125 Hz im Bereich B2 gemessen.

**Patentansprüche**

1. Verfahren zur Ermittlung der Frequenz $f_s$ eines abgetasteten periodischen symmetrischen ersten Signals (S1), bei dem ein Abtasttakt (AT) einer Frequenz $f_{abt}$ bereitgestellt wird, deren Wert wenigstens das Doppelte der Frequenz $f_s$ dieses ersten Signals (S1) beträgt, dadurch gekennzeichnet, daß aus dem ersten Signal (S1) eine digitale binäre Vorzeichenimpulsfolge (VZ) abgeleitet wird, daß ein Meßtakt (MT) einer definierten Meßimpulsdauer vorgesehen wird, daß das erste Signal (S1) mit dem Abtasttakt (AT) während der Meßimpulsdauer seriell-parallel umgesetzt wird, daß im parallelen zweiten Signal (S2) jeweils ein Bereich (B1–B5) erkannt wird, der zwischen zwei ganzzahligen Werten des Frequenz-Verhältnisses $L=f_{abt}/f_s$ liegt, daß in dem zweiten Signal (S2) Vorzeichen-Vergleichsmuster (VM, $\overline{VM}$) sowie davon abweichende Ausnahmevorzeichen (AVZ) erkannt werden, daß die Ausnahmevorzeichen (AVZ) während der Meßimpulsdauer gezählt werden, daß das Zählergebnis gespeichert wird, daß die Anzahl der zwischen aufeinanderfolgenden Ausnahmevorzeichen (AVZ) auftretenden Abtastwerte mehrfach hintereinander festgestellt und daraus die mittlere Anzahl (n) von Abtastwerten ermittelt wird, daß das Frequenzverhältnis L für den ermittelten Bereich (B1–B5) und die ermittelte mittlere Anzahl (n) von Abtastwerten festgestellt wird und daß aus dem Frequenzverhältnis L und der Abtastfrequenz $f_{abt}$ die Frequenz $f_s$ des ersten Signals (S1) festgestellt und diese angezeigt wird.

2. Verfahren zur Ermittlung der Frequenz $f_s$ eines abgetasteten periodischen symmetrischen ersten Signals (S1), bei dem ein Abtasttakt (AT) einer Frequenz $f_{abt}$ bereitgestellt wird, deren Wert wenigstens das Doppelte der Frequenz $f_s$ dieses ersten Signals (S1) beträgt, und bei dem der Bereich (B1–B5) bekannt ist, der zwischen zwei ganzzahligen Werten des Frequenz-Verhältnisses $L=f_{abt}/f_s$ liegt, dadurch gekennzeichnet, daß aus dem ersten Signal (S1) eine digitale binäre Vorzeichenimpulsfolge (VZ) abgeleitet wird, daß ein Meßtakt (MT) einer definierten Meßimpulsdauer vorgesehen wird, daß das erste Signal (S1) mit dem Abtasttakt (AT) während der Meßimpulsdauer seriell-parallel umgesetzt wird, daß in dem zweiten Signal (S2) Vorzeichen-Vergleichsmuster (VM, $\overline{VM}$) sowie davon abweichende Ausnahmevorzeichen (AVZ) erkannt werden, daß die Ausnahmevorzeichen (AVZ) während der Meßimpulsdauer gezählt werden, daß das Zählergebnis gespeichert wird, daß die Anzahl der zwischen aufeinanderfolgenden Ausnahmevorzeichen (AVZ) auftretenden Abtastwerten mehrfach hintereinander festgestellt und daraus die mittlere Anzahl (n) von Abtastwerten ermittelt wird, daß das Frequenzverhältnis L für den bekannten Bereich (B1–B5) und die ermittelte mittlere Anzahl (n) von Abtastwerten festgestellt wird und daß aus dem Frequenzverhältnis L und der Abtastfrequenz $f_{abt}$ die Frequenz $f_s$ des ersten Signals (S1) festgestellt und diese angezeigt wird.

3. Anordnung zur Durchführung des Verfahrens nach Anspruch 1 oder 2, dadurch gekennzeichnet, daß ein UND-Gatter (1) vorgesehen ist, dessen erster Eingang mit einem Eingang (2) für die Vorzeichenimpulse (VZ) und dessen zweiter Eingang mit einem Eingang (3) für den Meßtakt (MT) verbunden ist, daß ein Schieberegister (4) zur Seriell-Parallel-Umsetzung vorgesehen ist, dessen serieller Eingang mit dem Ausgang des UND-Gatters (1) und dessen Takteingang mit einem Eingang (5) für den Abtasttakt (AT) verbunden ist, daß eine Erkennungsfenster-Einstelleinrichtung (6) vorgesehen ist, deren Eingänge mit den parallelen Ausgängen des Schieberegisters (4) verbunden sind, daß zwei Ausnahmevorzeichen-Erkennungseinrichtungen (7, 8) vorgesehen sind, deren erste Eingänge mit den Ausgängen der Erkennungsfenster-Einstellvorrichtung (6) verbunden sind, daß ein erstes ODER-Gatter (9) vorgesehen ist, dessen erster Eingang mit dem Ausgang der ersten Ausnahmevorzeichen-Erkennungseinrichtung (7) und dessen zweiter Eingang mit dem Ausgang der zweiten Ausnahmevorzeichen-Erkennungseinrichtung (8) verbunden ist, daß eine Bereichs-Erkennungseinrichtung (10) vorgesehen ist, deren Eingang mit dem Ausgang des UND-Gatters (1), deren erste Ausgänge für ein Vergleichsmuster (VM) mit den zweiten Eingängen der ersten Ausnahmevorzeichen-Erkennungseinrichtung (7), deren zweite Ausgänge für das invertierte Vergleichsmuster ($\overline{\text{VM}}$) mit den zweiten Eingängen der zweiten Ausnahmevorzeichen-Erkennungseinrichtung (8) und deren dritte Ausgänge mit einem Steuereingang der Erkennungsfenster-Einstellvorrichtung (6) verbunden sind, daß ein Inverter (11) vorgesehen ist, dessen Eingang mit dem Eingang (3) für den Meßtakt (MT) verbunden ist, daß ein zweites ODER-Gatter (12) vorgesehen ist, dessen erster Eingang mit dem Ausgang des Inverters (11) und dessen zweiter Ausgang mit einem Eingang (13) für Rücksetzimpulse (R) verbunden ist, daß ein Zähler (14) vorgesehen ist, dessen Eingang mit dem Ausgang des ersten ODER-Gatters (9) und dessen Rücksetzeingang mit dem Ausgang des zweiten ODER-Gatters (12) verbunden ist, daß flankengesteuerte D-Flipflops (15) vorgesehen sind, deren eine Eingänge mit den Ausgängen des Zählers (14), deren andere Eingänge mit vierten Ausgängen der Bereichs-Erkennungseinrichtung (10), deren Takteingänge mit dem Ausgang des Inverters (11) und deren Rücksetzeingänge mit dem Eingang (13) für Rücksetzimpulse (R) verbunden sind, und daß ein Umcodierer (16) vorgesehen ist, dessen Eingänge mit den Ausgängen der D-Flipflops (15) verbunden sind und dessen Ausgänge (17) einen binären Code für eine Ziffernanzeige abgeben.

## Revendications

1. Procédé pour déterminer la fréquence $f_s$ d'un premier signal symétrique périodique échantillonné (S1), selon lequel on prépare une cadence d'échantillonnage (AT) possédant une fréquence $f_{\text{échantionnage}}$, dont la valeur est égale au moins au double de la fréquence $f_s$ de ce premier signal (S1), caractérisé par le fait qu'à partir du premier signal (S1) on obtient une suite numérique binaire d'impulsions de signes (VZ), qu'il est prévu une cadence de mesure (MT), dont les impulsions possèdent une durée définie, qu'on soumet le premier signal (S1) à une conversion série-parallèle, avec la cadence d'échantillonnage (AT) pendant la durée d'une impulsion de mesure, que dans le second signal parallèle (S2) on identifie respectivement une zone (B1–B5), qui est située entre deux multiples entiers du rapport des fréquences

$L = f_{\text{échantillonnage}}/f_s$,

que dans le second signal (S2), on identifie des modèles de référence de signes (VM, $\overline{\text{VM}}$) ainsi que des signes exceptionnels (AVZ) différents de ces modèles, que l'on compte les signes exceptionnels (AVZ) pendant la durée de l'impulsion e mesure, qu'on mémorise le résultat de comptage, qu'on détermine successivement et à plusieurs reprises le nombre des valeurs d'échantillonnage apparaissant entre des signes exceptionnels successifs (AVZ) et qu'on détermine, à partir de là, le nombre moyen (n) de valeurs d'échantillonnage, qu'on détermine le rapport des fréquences L pour la zone déterminée (B1–B5) et le nombre moyen déterminé (n) de valeurs d'échantillonnage, et qu'on détermine, à partir du rapport des fréquences L et de la fréquence d'échantillonnage $f_{\text{échantillonnage}}$ la fréquence $f_s$ du premier signal (S1) et qu'on l'affiche.

2. Procédé pour déterminer la fréquence $f_s$ d'un premier signal symétrique périodique échantillonné (S1), selon lequel on prépare une cadence d'échantillonnage (AT) possédant une fréquence $f_{\text{échantillonnage}}$, dont la valeur est égale au moins au double de la fréquence $f_s$ de ce premier signal (S1), et selon lequel la zone (B1–B5) qui est située entre deux multiples entiers du rapport des fréquences $L = f_{\text{échantillonnage}}/f_s$, est connue, caractérisé par le fait qu'à partir du premier signal (S1) on obtient une suite numérique binaire d'impulsions de signes (VZ), qu'il est prévu une cadence de mesure (MT), dont les impulsions possèdent une durée définie, qu'on soumet le premier signal (S1) à une conversion série-parallèle, avec la cadence d'échantillonnage (AT), pendant la durée d'une impulsion de mesure, que dans le second signal (S2), on identifie des modèles de référence de signes (VM, $\overline{\text{VM}}$) ainsi que des signes exceptionnels (AVZ) différents de ces modèles, que l'on compte les signes exceptionnels (AVZ) pendant la durée de l'impulsion de mesure, qu'on mémorise le résultat de comptage, qu'on détermine successivement et à plusieurs reprises le nombre des valeurs d'échantillonnage apparaissant entre des signes exceptionnels successifs (AVZ) et qu'on détermine, à partir de là, le nombre moyen (n) de valeurs d'échantillonnage, qu'on détermine le rapport des fréquences L pour la zone connue (B1–B5) et le nombre moyen déterminé (n) de valeurs d'échantillonnage, et qu'on détermine, à partir du rapport des fréquences L et de la fréquence d'échantillonnge $f_{\text{échantillonnage}}$ la fréquence $f_s$ du premier signal (S1) et qu'on l'affiche.

3. Dispositif pour la mise en œuvre du procédé suivant la revendication 1, caractérisé par le fait qu'il est prévu une porte ET (1), dont la première entrée est reliée à une entrée (2) pour les impulsions de signes (VZ) et dont la seconde entrée est reliée à une entrée (3) pour la cadence de mesure (MT), qu'il est prévu un registre à décalage (4) pour la conversion série/parallèle, dont l'entrée série est reliée à la sortie de la porte ET (1) et dont l'entrée de cadence est reliée à une entrée (5) pour la cadence d'échantillonnage (AT), qu'il est prévu un dispositif (6) de réglage de la fenêtre d'identification, dont les entrées sont reliées aux sorties en parallèle du registre à décalage (4), qu'il est prévu deux dispositifs (7, 8) d'identification de signes exceptionnels, dont les premières entrées sont reliées aux sorties du dispositif (6) de réglage de la fenêtre d'identification, qu'il est prévu une première porte OU (9), dont la première entrée est reliée à la sortie du premier dispositif (7) d'identification de signes exceptionnels et dont la seconde entrée est reliée à la sortie du second dispositif (8) d'identification de signes exceptionnels, qu'il est prévu un dispositif (10) d'identification de zones, dont l'entrée est reliée à la sortie de la porte ET (1), dont les premières sorties pour un modèle de référence (VM) sont reliées aux secondes entrées du premier dispositif (7) d'identification de signes exceptionnels, et dont les secondes entrées prévues pour le modèle de référence inversé ($\overline{VM}$) sont reliées aux secondes entrées du second dispositif (8) d'identification de signes exceptionnels et dont les troisièmes entrées sont reliées à une entrée de commande du dispositif (6) de réglage de la fenêtre d'identification, qu'il est prévu un inverseur (11), dont l'entrée est reliée à l'entrée (3) pour la cadence de mesure (MT), qu'il est prévu une seconde porte OU (12), dont la première entrée est reliée à la sortie de l'inverseur (11) et dont la seconde sortie est reliée à une entrée (13) prévue pour des impulsions de remise à l'état initial (R), qu'il est prévu un compteur (14), dont l'entrée est reliée à la sortie de la première porte OU (9), et dont l'entrée de remise à l'état initial est reliée à la sortie de la seconde porte ET (12), qu'il est prévu des bascules bistables de type D (15), commandées par les flancs des impulsions et dont des premières entrées sont reliées aux sorties du compteur (14), et dont les autres entrées sont reliées à des quatrièmes sorties du dispositif (10) d'identification de zones, et dont les entrées de cadence sont reliées à la sortie de l'inverseur (11) et dont les entrées de remise à l'état initial sont reliées à l'entrée (13) prévue pour les impulsions de remise à l'état initial (R), et qu'il est prévu un transcodeur (16), dont les entrées sont reliées aux sorties des bascules bistables de type D (15) et dont les sorties (17) délivrent un code binaire pour une indication chiffrée.

## Claims

1. Method of determining the frequency $f_s$ of a sampled, periodic symmetrical first signal (S1), in which a sampling clock signal (AT) is supplied with a frequency $f_{abt}$ whose value is at least double the frequency $f_s$ of this first signal (S1), characterized in that a digital, binary sign pulse sequence (VZ) is derived from the first sign (S1), in that a measuring clock signal (MT) with a determinate measuring pulse duration is provided, in that the first signal (S1) is converted from serial to parallel by means of the sampling clock signal (AT) during the measuring pulse duration, in that a range (B1–B5) which falls between two whole-numbered values of the frequency ratio $L = f_{abt}/f_s$ is recognized in each case in the parallel second signal (S2), in that sign comparison patterns (VM, $\overline{VM}$) and exception signs (AVZ) deviating therefrom are recognized in the second signal (S2), in that the exception signs (AVZ) are counted during the mesuring pulse duration, in that the counting result is stored, in that the number of the sample values occurring between consecutive exception signs (AVZ) is established multiply one after another and the mean number (n) of the sample values is determined therefrom, in that the frequency ratio L for the determined range (B1–B5) and the determined mean number (n) of sample values are established, and in that the frequency $f_s$ of the first signal (S1) is established from the frequency ratio L and the sampling frequency $f_{abt}$ and displayed.

2. Method of determining the frequency $f_s$ of a sampled, periodic symmetrical first signal (S1), in which a sampling clock signal (AT) is supplied with a frequency $f_{abt}$ whose value is at least double the frequency $f_s$ of this first signal (S1), and in which the range B1–B5 (which falls between two whole-numbered values of the frequency ratio $L = f_{abt}/f_s$ is known, characterized in that a digital, binary sign pulse sequence (VZ) is derived from the first signal (S1), in that a measuring clock signal (MT) with a determinate measuring pulse duration is provided, in that the first signal (S1) is converted from series to parallel by means of the sampling clock signal (AT) during the measuring pulse duration, in that sign comparison patterns (VM, $\overline{VM}$) and exception signs (AVZ) deviating therefrom are recognized in the second signal (S2), in that the exception signs (AVZ) are counted during the measuring pulse duration, in that the counting result is stored, in that the number of the sample values occurring between consecutive exception signs (AVZ) is established multiply one after another and the mean number (n) of the sample values is determined therefrom, in that the frequency ratio L for the known range (B1–B5) and the determined mean number (n) of sample values are established, and in that the frequency $f_s$ of the first signal (S1) is established from the frequency ratio L and the sampling frequency $f_{ab}$ and displayed.

3. Apparatus for carrying out the method according to Claim 1 or 2, characterized in that an AND-gate is provided whose first input is connected to an input (2) for the sign pulses (VZ) and whose second input is connected to an input (3) of the measuring clock signal (MT), in that a shift register (4) for series-parallel conversion is provided whose series input is connected to the ouput of the AND-gate (1) and whose clock input is connected to an input (5) of the sampling clock signal (AT), in that a recognition-window setting device (6) is provided whose inputs are connected to the parallel outputs of the shift register (4), in that two exception-sign recognition devices (7, 8) are provided whose first inputs are connected to the ouptuts of the recognition-window setting device (6), in that a first OR-gate (9) is provided whose first input is connected to the output of the first exception-sign recognition device (7) and whose second input is connected to the output of the second exception-sign recognition device (8), in that a range recognition device (10) is provided whose input is connected to the output of the AND-gate (1), whose first outputs for a comparison pattern (VM) are connected to the second inputs of the first exception-sign recognition device (7), whose second outputs for the inverted comparison pattern ($\overline{VM}$) are connected to the second inputs of the second exception-sign recognition device (8), and whose third outputs are connected to a control input of the recognition-window setting device (6), in that an inverter (11) is provided whose input is connected to the input (3) for the measuring clock signal (MT), in that a second OR-gate (12) is provided whose first input is connected to the output of the inverter (11) and whose second output is connected to an input (13) for resetting pulses (R), in that a counter (14) is provided whose input is connected to the output of the first OR-gate (9) and whose resetting input is connected to the output of the second OR-gate (12), in that edge controlled D flip-flops (15) are provided whose first inputs are connected to the outputs of the counter (14), whose other inputs are connected to fourth outputs of the range recognition device (10), whose clock inputs are connected to the output of the inverter (11) and whose resetting inputs are connected to the input (13) for resetting pulses (R) and in that a recoder (16) is provided whose inputs are connected to the outputs of the D flip-flops (15) and whose outputs (17) emit a binary code for a digit display.

EP 0 309 921 B1

**FIG 1a**

fabt = 4·fs, m=4

**FIG 1b**

fabt = 5·fs, m = 5

**FIG 2a**

p=5, q=2, fabt = 2,5·fs

**FIG 2b**

p=7, q=2, fabt = 3,5·fs

**FIG 3**

p=7 q=2 fabt = 3,5·fs

# FIG 4

| B | VZ : + , —    AVZ : ⊕.., θ | L | n | VM | V̄M |
|---|---|---|---|---|---|
| | **2 < L < 3** | | | | |
| B1 | + ⊕ - + - + ⊕ - + - + ⊕ - + - + ⊕ -<br>- θ + - + - θ + - + - θ + - + - θ + | 2,5<br>2,5 | 5 | + + - | - - + |
| | **3 ≦ L < 4** | | | | |
| B2 | + + - + + - + + - + + - + + -.+ + -<br>+ + - + + - θ + + - + + - θ + + - + | 3<br>3,5 | 7 | + + - - | - - + + |
| | **4 < L < 5** | | | | |
| B3 | + + ⊕ - - + + - - + + ⊕ - - + + - - | 4,5 | 9 | + + + - - | - - - + + |
| | **5 ≦ L < 6** | | | | |
| B4 | + + + - - + + + - - + + + - - + + + - - + + +<br>+ + + - - + + + - - θ + + + - - + + + - - θ + | 5<br>5,5 | 11 | + + + - - - | - - - + + |
| | **6 < L < 7** | | | | |
| B5 | + + + ⊕ - - - + + + - - - + + + ⊕ - - - + + + - | 6,5 | 13 | + + + + - - - | - - - - + + + |

EP 0 309 921 B1

# FIG 5

# FIG 6